# EUROPÄISCHE PATENTSCHRIFT

(11) **EP 3 095 713 B1**
(45) Veröffentlichungstag und Bekanntmachung des Hinweises auf die Patenterteilung: **02.08.2017**
(21) Anmeldenummer: 15001497.5
(22) Anmeldetag: 19.05.2015
(51) Int. Cl.: B64G 1/10, B64G 1/50, H05K 7/20

(54) **GERÄTETRÄGERTAFEL EINES SATELLITEN**
DEVICE HOLDER PANEL OF A SATELLITE
PANNEAU PORTE-OUTILS POUR UN SATELLITE

(43) Veröffentlichungstag der Anmeldung: 23.11.2016
(73) Patentinhaber: Airbus DS GmbH, 82024 Taufkirchen (DE)
(72) Erfinder: Bose, Guido, 88090 Immenstaad (DE); Grasl, Andreas, 83101 Rohrdorf/Thansau (DE)
(74) Vertreter: Frenkel, Matthias Alexander

(56) Entgegenhaltungen:
- EP-A1- 0 869 063
- EP-A2- 0 780 295
- FR-A1- 2 898 872

## Beschreibung

### TECHNISCHES GEBIET

Die vorliegende Erfindung betrifft eine Geräteträgertafel eines Satelliten zur Aufnahme von mit einer Mehrzahl von elektrische und/oder elektronische Baugruppen aufnehmenden Elektronikkästen. Die Erfindung betrifft weiterhin einen Satelliten mit einer Mehrzahl von Geräteträgertafeln. Die Erfindung betrifft schließlich auch ein Verfahren zur Integration von mit elektrische und/oder elektronische Baugruppen aufweisenden Elektronikkästen ausgestatteten Geräteträgertafeln.

### HINTERGRUND DER ERFINDUNG

In der konventionellen Satellitentechnik werden die elektrischen und elektronischen Subsysteme, zum Beispiel die Stromversorgungseinheit PCDU (Power Control and Distribution Unit), die ausgelagerte Schnittstelleneinheit RIU (Remote Interface Unit), den Bordcomputer OBC (On-Bord Computer) oder die Sensorik, über Elektronikkästen oder Elektronikboxen maßgeschneidert für jedes neue Satellitensystem neu entwickelt und für jedes Projekt neu gebaut. Dieses Konzept ist für eine Serienproduktion ungeeignet. Diese Elektronikkästen sind meist sehr groß und schwer und daher nur mit Hilfe eines Krans integrierbar. Zudem sind die elektrischen Schnittstellen, wie beispielsweise Stecker, zumeist sehr schwer zugänglich. Es werden zum Beispiel üblicherweise Kabelbäume mit zum Teil 20 verschiedenen Steckertypen und zum Teil 40 Steckern pro Box gebaut, welche manuell sehr zeitaufwändig Stecker für Stecker mit dem Kabelbaum verbunden werden müssen.

### STAND DER TECHNIK

Aus dem Militärluftfahrzeugbau ist das so genannte "ARINC-Interface-System" bekannt, bei welchem die mechanischen und die elektrischen Schnittstellen der Elektronik Boxen standardisiert sind. Die elektrische Verbindung mit dem System wird hier automatisch während der mechanischen Verbindung der Boxen mit der Flugzeugstruktur hergestellt. Die Bauelemente dieses ARINC-Interface-Systems, zum Beispiel die Stecker, sind jedoch für die Raumfahrt nicht qualifiziert.

Ein Geräteträgertafel eines Satelliten ist beispielsweise aus dem Dokument US 2007/0221786 A1 bekannt.

### DARSTELLUNG DER ERFINDUNG

Aufgabe der vorliegenden Erfindung ist es, eine Geräteträgertafel eines Satelliten so weiterzubilden, dass mit weniger Arbeitsaufwand eine schnellere Integration eines Satelliten ermöglicht ist. Eine weitere Aufgabe besteht darin, ein Verfahren zur Integration einer solchen Geräteträgertafel anzugeben.

Der auf die Geräteträgertafel gerichtete Teil der Aufgabe wird gelöst durch eine Geräteträgertafel mit den Merkmalen des Patentanspruchs 1.

Bei dieser Geräteträgertafel eines Satelliten zur Aufnahme von einer Mehrzahl von elektrische und/oder elektronische Baugruppen aufnehmenden Elektronikkästen, wobei die Elektronikkästen untereinander elektrisch verbunden oder verbindbar sind, ist vorgesehen, dass die Geräteträgertafel mit zumindest einer Dockingstruktur versehen ist, dass die zumindest eine Dockingstruktur und/oder eine Grundplatte der Geräteträgertafel erste mechanische Verbindungsmittel zur Halterung von Elektronikkästen aufweist, dass die zumindest eine Dockingstruktur erste elektrische Verbindungsmittel zur elektrischen Verbindung mit den Elektronikkästen aufweist und dass die Elektronikkästen mit mechanischen Gegenverbindungsmitteln und elektrischen Gegenverbindungsmitteln versehen sind, um damit einen jeweiligen Elektronikkasten an der Dockingstruktur und/oder der Geräteträgertafel mechanisch zu haltern und elektrisch zu kontaktieren.

### VORTEILE

Der modulare Aufbau mit vorgefertigten Elektronikkästen, die schnell und einfach an der auf den Geräteträgertafeln vorgesehenen, auch als "Harness" bezeichneten Dockingstruktur mechanisch anbringbar und mit dieser elektrisch verbindbar sind, erleichtert und beschleunigt die Montage der elektronischen Geräte und damit die gesamte Integration des Satelliten. Der Einbau der Dockingstruktur, die einen Kabelbaum-Bus ("Harness Bus") bildet, kann in einem halben bis einem Tag durchgeführt werden im Vergleich zu fünf Tagen Integrationszeit beim Einbau eines konventionellen Kabelbaums. Der mechanische Einbau der Elektronikkästen in den Satelliten und die Integration der Elektronikkästen mit dem entsprechenden Kabelbaum des Satelliten, kann beim erfindungsgemäßen Aufbau in wesentlich kürzerer Zeit durchgeführt werden.

Weitere bevorzugte und vorteilhafte Ausgestaltungsmerkmale der erfindungsgemäßen Geräteträgertafel sind Gegenstand der Unteransprüche 2 bis 8.

Gemäß einer bevorzugten Weiterbildung der Erfindung ist vorgesehen, dass die ersten mechanischen Verbindungsmittel und die ersten elektrischen Verbindungsmittel der Dockingstruktur an zumindest einer Seite der Dockingstruktur in gleichmäßigem Abstand und in einer vorgegebenen, sich entlang der Seite der Dockingstruktur wiederholender Anordnung vorgesehen sind und so ein Aufnahmeraster für die Elektronikkästen bilden und dass die mechanischen Gegenverbindungsmittel und die elektrischen Gegenverbindungsmittel der Elektronikkästen in ihrer Positionierung am betreffenden Elektronikkasten und in ihrem Abstand zueinander an die Positionierung und den relativen Abstand der ersten mechanischen Verbindungsmittel und der ersten elektrischen Verbindungsmittel der Dockingstruktur des Satelliten angepasst sind. Die so von den mechanischen Verbindungsmitteln gebildete mechanische Schnittstelle und die so von den elektrischen Verbindungsmitteln gebildete elektrische Schnittstelle ist auf diese Weise standardisiert. Die Elektronikkästen sind vorzugsweise auch hinsichtlich ihrer Abmessungen standardisiert.

Vorteilhaft ist es auch, wenn die jeweilige Dockingstruktur zweite elektrische Verbindungsmittel und vorzugsweise auch zweite mechanische Verbindungsmittel aufweist, über die die Dockingstruktur mit einer weiteren Dockingstruktur verbindbar ist. Dadurch wird die Dockingstation erweiterbar.

Vorteilhafterweise kann die Dockingstruktur als gitterartiges Kastenprofil ausgebildet sein, in dessen Innerem elektrische Versorgungs- und Verbindungsleitungen verlaufen, die mit den elektrischen Verbindungsmitteln verbunden sind. Dadurch verlaufen die Kabel des auch als "Wiring-Harness" bezeichneten Kabelbaums geschützt und aufgeräumt im Inneren der Dockingstruktur.

Vorzugsweise ist die Dockingstruktur auf der zugeordneten Geräteträgertafel als rechteckiger Ring oder als I-förmiger Balken ausgebildet.

In einer weiteren bevorzugten Ausgestaltung der Erfindung sind die ersten mechanischen Verbindungsmittel und die ersten elektrischen Verbindungsmittel zur Anbringung der Elektronikkästen an den seitlichen Flächen der Dockingstruktur, also rechtwinklig zur Geräteträgertafel, vorgesehen, wobei sie bei einer ringförmigen Dockingstruktur vorzugsweise auf der Innenseite des Rings ausgebildet sind. Diese Ausgestaltung ermöglicht es, dass die mit der Dockingstruktur verbundenen Elektronikkästen auf der Geräteträgertafel aufliegen und dort befestigt werden können. Auch kann durch den Flächenkontakt zwischen dem Elektronikkasten und der Geräteträgertafel eine wirksame Wärmeabfuhr aus dem Elektronikkasten in die Geräteträgertafel geschaffen werden.

Besonders vorteilhaft ist es, wenn die zweiten elektrischen Verbindungsmittel Steckverbinder, die an (parallel zur Geräteträgertafel verlaufenden) oberen Flächen der Dockingstruktur vorgesehen sind, und Gegensteckverbinder aufweisen, die an seitlichen Flächen der Dockingstruktur im Bereich des Randes der zugeordneten Geräteträgertafel vorgesehen sind, wobei die Gegensteckverbinder bei einer ringförmigen Dockingstruktur vorzugsweise auf der Außenseite des Rings ausgebildet sind. Dieser Aufbau gestattet es auf einfache Weise, zwei oder mehrere mit einer Dockingstruktur und daran angeordneten Elektronikkästen versehene Geräteträgertafeln elektrisch funktional so zusammenzustecken, dass eine dreidimensionale Anordnung aus diesen Geräteträgertafeln gebildet wird. Zusätzlich können diese Geräteträgertafeln oder die auf ihnen angeordneten Dockingstrukturen mechanisch miteinander verbunden sein.

Die jeweilige Dockingstruktur weist als mechanisches Gerüst bevorzugt eine Leichtmaterial-Gitterkonstruktion, beispielsweise aus CFK oder Aluminium, auf und bildet so eine Art Korb, in welchem die kompletten Kabelbäume mit den ersten elektrischen Verbindungsmitteln für die Verbindung mit den Elektronikkästen und mit den zweiten elektrischen Verbindungsmitteln für die Verbindung mit anderen Dockingstrukturen aufgenommen sind. Die ersten und die zweiten Verbindungsmittel sind bevorzugt von handelsüblichen, genormten ARINC-Verbindern gebildet, wobei es besonders vorteilhaft ist, wenn nur ein einziger ARINC-Verbinder-Typ Verwendung findet.

Besonders vorteilhaft ist es auch, wenn die Grundplatte im Bereich der ersten mechanischen Verbindungsmittel mit Wärmekontaktflächen versehen ist, auf denen ein mit den mechanischen Verbindungsmitteln in Eingriff stehender Elektronikkasten mit einer Gehäusefläche an seiner Unterseite in wärmeleitendem Kontakt aufliegt. Dadurch wird eine thermische Schnittstelle zwischen dem Elektronikkasten und der Grundplatte gebildet, die eine wirksame Wärmeableitung vom Elektronikkasten in die Grundplatte ermöglicht. Die Wärmekontaktflächen können unmittelbar Teil der Oberfläche der Grundplatte sein oder sie können an mit der Grundplatte verbundenen thermischen Verbindungsmitteln vorgesehen sein.

In einer anderen vorteilhaften Weiterbildung einer mit zumindest einem Elektronikkasten versehenen Geräteträgerplatte sind die in einem jeweiligen Elektronikkasten vorgesehenen elektrischen und/oder elektronischen Baugruppen (elektrischen Geräte und/oder elektronischen Schaltungsanordnungen) mit einer Selbsttesteinrichtung versehen, die ausgebildet ist, um die Funktionsfähigkeit des entsprechenden Elektronikkastens zu überprüfen. Eine solche Selbsttesteinrichtung erleichtert die autonome Überprüfung der Funktionsfähigkeit einzelner Elektronikkästen. Diese Selbsttesteinrichtung der Elektronikkästen ermöglicht auch das Vorsehen einer eigenständigen übergeordneten intelligenten Testeinrichtung IDAS (Integrated Data Acquisition and Test System) als eigenständige Test-Adapter-Box.

Vorteilhaft ist unter Verwendung der erfindungsgemäßen Geräteträgertafeln ein Satellit gemäß Anspruch 9 gebildet.

Der auf das Verfahren gerichtete Teil der Aufgabe wird gelöst durch das Verfahren mit den Merkmalen des Patentanspruchs 10.

Dieses erfindungsgemäße Verfahren zur Integration von mit elektrische und/oder elektronische Baugruppen aufweisenden Elektronikkästen ausgestatteten Geräteträgertafeln in einen Satelliten umfasst die folgenden Schritte:
- Vormontage von zumindest einer Dockingstruktur wobei im Inneren der Dockingstruktur elektrische Versorgungs- und Verbindungseinrichtungen verlegt und mit an den Seiten der Dockingstruktur vorgesehenen elektrischen Verbindungsmitteln zur Bildung eines Kabelbus' verbunden werden;
- Testen des Kabelbus';
- Anbringen einer Dockingstruktur mit dem getesteten und funktionsfähigen Kabelbus auf einer ersten Seite der Geräteträgertafel;
- optionales Anbringen einer weiteren Dockingstruktur mit einem getesteten und funktionsfähigen Kabelbus auf einer von der ersten Seite abgewandten zweiten Seite der Geräteträgertafel;
- Bereitstellen von zumindest einem Elektronikkasten, in den elektrische und/oder elektronische Baugruppen und Anordnungen von zumindest einer der Baugruppen integriert, also eingebaut und, vorzugsweise mittels einer integrierten Selbsttesteinrichtung, getestet worden sind;
- sequentielle Integration des zumindest einen Elektronikkastens mit der Geräteträgertafel, wobei jeweils folgende Schritte durchgeführt werden:
   -- vorläufige mechanische Anbringung des Elektronikkastens auf der Geräteträgertafel;
   -- elektrische Verifikation der elektrischen Schnittstelle zwischen dem Elektronikkasten und dem Kabelbus;
   -- Herstellen einer lösbaren elektrischen Verbindung zwischen dem Elektronikkasten und dem Kabelbaum mittels der ersten elektrischen Verbindungsmittel und der elektrischen Gegenverbindungsmittel;
- Integration der auf diese Weise vorgefertigten Geräteträgertafel in den Satelliten.

Die jeweilige Dockingstruktur mit den integrierten Kabelbäumen und den damit verbundenen elektrischen Verbindungsmitteln bildet einen integrierten "Harness-Bus" und wird als eine einzige Einheit komplett gefertigt, getestet und eingebaut. Auch der jeweilige Elektronikkasten ist vorgefertigt und getestet. Somit müssen bei der Integration nur noch vorgefertigte und auf ihre Funktionsfähigkeit hin getestete Baugruppen elektrisch integriert und mechanisch und thermal miteinander verbunden werden. "Elektrisch integriert" bedeutet, dass jedes elektrische Signal zwischen einem Elektronikkasten und dem Kabelbaum in der Dockingstruktur verifiziert wird, bevor die finale Steckung der Stecker erfolgt.

Die Herstellung der elektrischen Steckverbindung zwischen einem Elektronikkasten und der Dockingstruktur erfolgt vorzugsweise im Moment der endgültigen mechanischen Verbindung zwischen Elektronikkasten und Dockingstruktur ("Plug and Play"). Es ist daher nicht mehr erforderlich, Steckverbindungen manuell (unter oft fast unmöglichen Zugänglichkeiten) zusammenzufügen. Dieses Integrationsverfahren ist für eine Serienfertigung ideal.

Bevorzugte Ausführungsbeispiele der Erfindung mit zusätzlichen Ausgestaltungsdetails und weiteren Vorteilen sind nachfolgend unter Bezugnahme auf die beigefügten Zeichnungen näher beschrieben und erläutert.

### KURZE BESCHREIBUNG DER ZEICHNUNGEN

Es zeigt:
- Fig. 1: eine perspektivische Ansicht eines Ausschnitts einer Geräteträgertafel mit Dockingstruktur und einem Elektronikkasten;
- Fig. 2: eine perspektivische Ansicht einer dreidimensionalen Anordnung von drei mit rechteckringförmiger Dockingstruktur und Elektronikkästen versehenen Geräteträgertafeln und
- Fig. 3: eine perspektivische Ansicht einer dreidimensionalen Anordnung von drei mit doppel-T-förmiger Dockingstruktur und Elektronikkästen versehenen Geräteträgertafeln.

### DARSTELLUNG VON BEVORZUGTEN AUSFÜHRUNGSBEISPIELEN

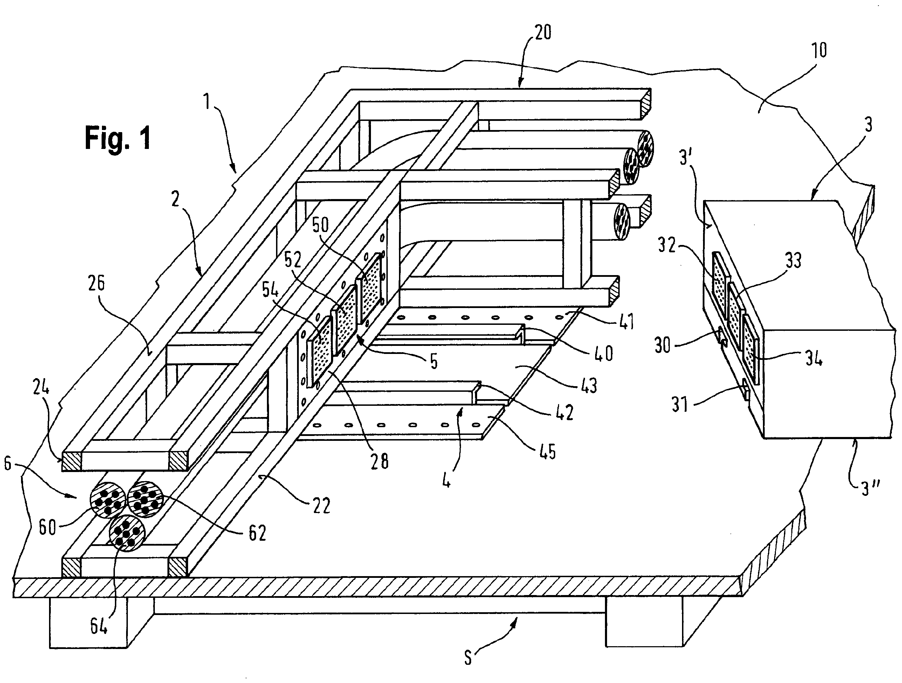

Fig. 1 zeigt eine perspektivische Ansicht einer mit einer schematisch dargestellten Struktur S eines Satelliten verbundenen Geräteträgertafel 1. Auf einer Grundplatte 10 der Geräteträgertafel 1 ist eine Dockingstruktur 2 befestigt, die aus einem abgewinkelten, kastenartigen Gitterprofil 20 besteht, welches aus einem Leichtmaterial, wie beispielsweise einem Kohlefaser-Verbundwerkstoff (CFK) oder einem Leichtmetall (z. B. Aluminium) gebildet ist. Die Dockingstruktur 2 weist eine innere Seite 22 und eine äußere Seite 24 auf, die beide im Wesentlichen rechtwinklig zur Ausdehnungsfläche der Grundplatte 10 ausgerichtet sind. Die Oberseite 26 der Dockingstruktur 2 verläuft im Wesentlichen parallel zur Fläche der Grundplatte 10. Im Inneren der Dockingstruktur 2 verlaufen elektrische Versorgungs- und Verbindungsleitungen 6, die im gezeigten Beispiel drei Kabelbäume 60, 62, 64 umfassen.

Das Gittergerüst 20 kann mit Abdeckplatten 28 versehen sein, die Bereiche des Gittergerüstes 20 verschließen oder verkleiden. Im gezeigten Beispiel ist lediglich eine Abdeckplatte 28 an der inneren Seite 22 dargestellt. Es können aber derartige Abdeckplatten 28 auch an der äußeren Seite 24 oder an der oberen Seite 26 angebracht sein.

Die Abdeckplatte 28 ist mit im gezeigten Beispiel drei elektrischen Steckverbindern 50, 52, 54 versehen, die zusammen erste elektrische Verbindungsmittel 5 der Dockingstruktur 2 bilden. Diese Steckverbinder 50, 52, 54 sind mit dem im Inneren der Dockingstruktur 2 verlaufenden elektrischen Versorgungs- und Verbindungsleitungen elektrisch verbunden. Es können auch mehr oder weniger als drei elektrische Steckverbinder vorgesehen sein.

Vor dem mit der Abdeckplatte 28 versehenen Abschnitt der Dockingstruktur 2 sind auf der Grundplatte 10 rechtwinklig zur Erstreckung der Abdeckplatte 28 zwei seitlich voneinander beabstandete Schienen 40, 42 auf der Grundplatte 10 angebracht, die mechanische Verbindungsmittel 4 bestimmen. Zwischen den beiden Schienen 40, 42 und jeweils seitlich neben diesen Schienen sind plattenartige Wärmekontaktflächen 41, 43, 45 auf der Grundplatte 10 angebracht, die in engem wärmeleitenden Kontakt mit der Oberfläche der Grundplatte 10 stehen.

In Fig. 1 ist weiterhin ein Elektronikkasten 3 gezeigt, der elektronische Geräte und/oder elektronische Schaltungsanordnungen aufnimmt. Auf der in der perspektivischen Ansicht der Fig. 1 sichtbaren und der Abdeckplatte 28 der Dockingstruktur 2 zugewandten Stirnseite 3' des Elektronikkastens 3 sind im gezeigten Beispiel drei elektrische Steckverbinder 32, 33, 34 vorgesehen, die jeweils ein elektrisches Gegenverbindungsmittel zum entsprechend gegenüber gelegenen Steckverbinder 50, 52, 54 der Abdeckplatte 28 bilden. Es können auch mehr oder weniger als drei elektrische Steckverbinder vorgesehen sein.

Im unteren Bereich der Stirnseite 3' des Elektronikkastens 3 sind mechanische Gegenverbindungsmittel 30, 31 vorgesehen, die als Nuten ausgebildet sind, welche im Querschnitt dem Querschnitt der Schienen 40, 42 entsprechen und sich an der Unterseite des Elektronikkastens 3 entlang erstrecken. Der Elektronikkasten 3 kann auf diese Weise auf die Schienen 40, 42 aufgeschoben werden, indem diese Schienen 40, 42 in eine jeweils zugeordnete Nut (mechanische Gegenverbindungsmittel 30, 31) eingeführt werden. Der Elektronikkasten 3 kann dann entlang der Schiene 40, 42 in Richtung auf die Abdeckplatte 28 der Dockingstruktur 2 geschoben werden, bis die elektrischen Steckverbinder 50, 52, 54 der ersten elektrischen Verbindungsmittel 5 mit den entsprechenden elektrischen Gegenverbindungsmitteln 32, 33, 34 an der Stirnseite 3' des Elektronikkastens 3 in Eingriff geraten und elektrische Verbindungen zwischen dem Elektronikkasten 3 und der Dockingstruktur 2 herstellen. In dieser elektrisch kontaktierenden Position wird der Elektronikkasten 3 über (nicht gezeigte) Arretiermittel an der Dockingstruktur 2 und/oder an der Grundplatte 10 fixiert. Der Elektronikkasten 3 liegt dabei mit seiner Unterseite 3" auf den thermischen Kontaktplatten 41, 43, 45 auf und stellt dort eine flächige thermisch leitende Verbindung her.

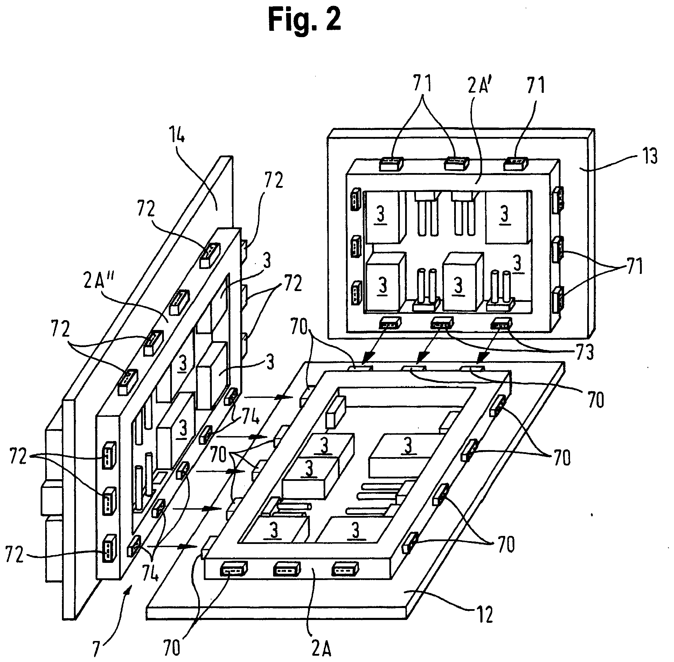

Fig. 2 zeigt eine perspektivische Explosionsansicht von drei räumlich dreidimensional zusammenfügbaren Geräteträgertafeln 12, 13, 14, auf denen jeweils eine rechteckringartige Dockingstruktur 2A, 2A', 2A" vorgesehen ist. An jeder dieser Dockingstrukturen 2A, 2A', 2A" sind Elektronikkästen 3 auf die in Verbindung mit Fig. 1 beschriebene Weise im Inneren der rechteckringartigen Dockingstruktur angebracht.

In Fig. 2 ist besonders gut zu erkennen, dass die jeweilige Dockingstruktur 2A, 2A', 2A" an ihrer äußeren Seite mit zweiten elektrischen Verbindungsmittel 7 versehen ist, die gebildet werden von elektrischen Steckverbindern 70, 71, 72 und welche in der Regel gleichartige Steckverbinder sind. Auf der Oberseite der Dockingstrukturen 2A, 2A', 2A" der Geräteträgertafeln 13 bzw. 14 sind als zweite elektrische Verbindungsmittel Gegensteckverbinder 73, 74 vorgesehen, die so ausgebildet und angeordnet sind, dass sie mit den auf der äußeren Seite einer anderen Dockingstruktur 2A, 2A', 2A" vorgesehenen Steckverbindern 70, 71, 72 zur Herstellung von elektrisch leitenden Verbindungen zusammensteckbar sind, wie die Pfeile in Fig. 2 symbolisieren.

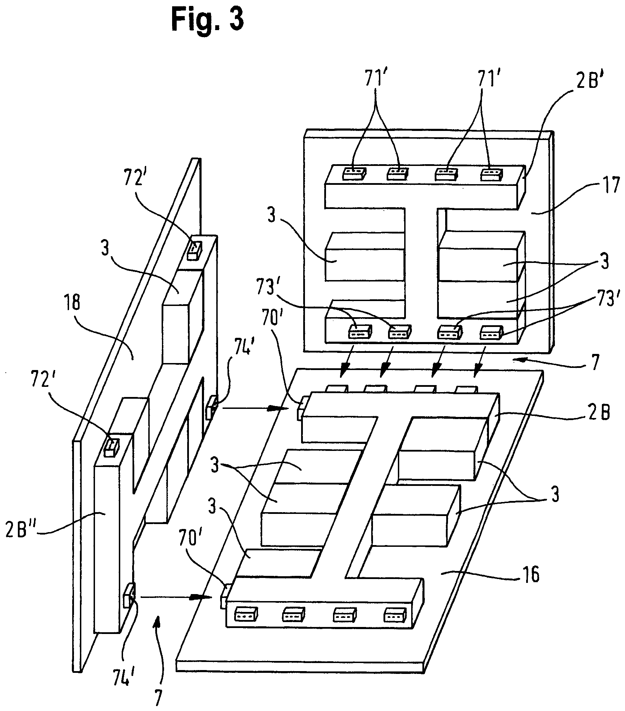

Fig. 3 zeigt eine gegenüber Fig. 2 abgewandelte Variante von drei zu einem dreidimensionalen räumlichen Gebilde zusammensteckbaren Geräteträgertafeln 16, 17, 18, auf denen jeweils eine doppel-T-förmige Dockingstruktur 2B, 2B', 2B" vorgesehen ist. Auch diese Dockingstrukturen 2B, 2B', 2B" sind, wie in Verbindung mit Fig. 2 beschrieben worden ist, mit entsprechenden ersten und zweiten elektrischen Verbindungsmitteln 70', 71', 72', 73', 74' versehen, die den entsprechenden elektrischen Verbindungsmitteln 70, 71, 72, 73, 74 in Fig. 2 entsprechen.

Auf den Innenseiten der jeweiligen T-förmigen Dockingstruktur 2B, 2B', 2B" sind, wie in Fig. 3 zu erkennen ist, Elektronikkästen 3 angeordnet, die in einer Weise, wie es in Verbindung mit Fig. 1 beschrieben worden ist, mit der jeweiligen Dockingstruktur zusammengefügt werden. Auch diese drei Geräteträgertafeln 16, 17, 18 lassen sich mittels der zweiten elektrischen Verbindungsmittel 7, wie dies in Verbindung mit Fig. 2 gezeigt und beschrieben worden ist, zur Herstellung von elektrischen Verbindungen zwischen den jeweiligen Dockingstrukturen 2B, 2B', 2B" zusammenfügen, wie dies durch die Pfeile in Fig. 3 symbolisiert ist.

Vorzugsweise sind die Elektronikkästen hinsichtlich ihrer Grundfläche (Länge und Breite), der mechanischen Schnittstelle und der elektrischen Schnittstelle zu den mit der Dockingstruktur versehenen Geräteträgertafeln standardisiert. Die Höhe der Elektronikkästen kann unterschiedlich sein, wobei vorzugsweise ein Höhen-Rastermaß vorgesehen ist. Die Elektronikkästen weisen daher untereinander die gleiche Grundfläche und die gleichen mechanischen und elektrischen Schnittstellen auf, so dass jeder Elektronikkasten (unabhängig von seiner Höhe) an einem standardisierten Aufnahmeplatz an der Dockingstruktur anbringbar und elektrisch mir der Dockingstruktur sowie mechanisch mit der Dockingstruktur und/oder der Grundplatte koppelbar ist.

Die Elektronikkästen innerhalb eines Satellitensystems weisen als standardisierte Boxen die gleichen Abmessungen und die gleichen mechanischen (ARINCbasierenden) Schnittstellen zum Satelliten haben. Die Boxen werden über die mechanischen Führungs-/Halteschienen auf der Grundplatte 10 zu den Steckern geführt.

Diese standardisierten Elektronikkästen werden über die Steckersysteme der ersten elektrischen Verbindungsmittel und der elektrischen Gegenverbindungsmittel (zum Beispiel ARINC-Steckersysteme) mit der Dockingstruktur der Geräteträgertafel verbunden. Die elektrische Verbindung dem Elektronikkasten wird bei ARINC-Steckern gleichzeitig zusammen mit der mechanischen Verbindung hergestellt.

Des Weiteren können auch Power-Elektrik-Elemente, wie beispielsweise Batterien, in der beschriebenen Weise mit der Dockingstruktur verbunden werden. Diese Stromversorgungselemente besitzen bevorzugt die Abmessungen eines Elektronikkastens.

Legt man die Idee zugrunde, auf einer ersten Geräteträgertafel und einer zweiten Geräteträgertafel einer dreidimensionalen Anordnung (Fig. 2 und 3) die Satelliten-Service-Funktionen der Stromversorgungseinheit PCDU (Power Control and Distribution Unit), der ausgelagerten Schnittstelleneinheit RIU (Remote Interface Unit) und des Bordcomputers OBC (On-Bord Computer) zu etablieren, so könnten deren Nominal-Funktionen auf der ersten Geräteträgertafel und die redundanten Funktionen auf der zweiten Geräteträgertafel realisiert werden. Würde die dritte Geräteträgertafel ein Instrument beinhalten, welches von der ersten Geräteträgertafel und der zweiten Geräteträgertafel elektrisch versorgt würde, so wäre eine hinreichende elektrische Funktions-Redundanz gegeben. Weitere Geräteträgertafeln, die in den Figuren 2 und 3 nicht gezeigt sind, und die die in den Figuren 2 und 3 gezeigten Anordnungen zu einem Kubus bilden, könnten Lageregelungssysteme, Tanks und/oder Funksysteme (RF-Systeme) beinhalten. Jedes Panel welches PCDU-Stromversorgungseinheiten und elektronische Sicherungen LCL's (Line Control Limiter) beinhaltet, sollte mit einem eigenen Main-Bus einschließlich elektrischer Stromregeleinrichtung PCU (Power Control Unit) und Solarzellenstromkonverter (Solar Array Converter) ausgerüstet sein

Es kann auch jede Geräteträgertafel mit einer eigenen Batterie ausgerüstet sein, welche an der Außenseite einer der Geräteträgertafeln montiert werden sollte.

Der Haupt-Bus mit Stromregeleinrichtung PCU, Dioden und Batterie-Relais, ebenso wie der Arduino-Controller kann entweder in den Kabelkanal oder in einen in der entsprechenden Geräteträgertafel geschaffenen Hohlraum eingebettet sein. Die Haupt-Busse der einzelnen Geräteträgertafeln können unter Zuhilfenahme von noch zu entwickelnden mechanischen Bodenhilfsmitteln (MGSE: Mechanical Ground Support Equipment) zum Beispiel über Power-ARINC-Stecker auf dem EMV-Kabelkanal miteinander verbunden werden.

Auf der ersten Geräteträgertafel und der zweiten Geräteträgertafel können die Satelliten-Service-Funktionen von PCDU, RIU und OBC etabliert sein. Deren Nominal-Funktionen sind auf der ersten Geräteträgertafel und die redundanten Funktionen auf der zweiten Geräteträgertafel realisiert. Da beide Geräteträgertafeln jeweils eine eigene Batterie aufweisen, ist die Stromversorgung auch redundant. Die Solar Panel- und Umbilical-Versorgung erfolgt über die beim Start der Rakete zugewandte hinterste Geräteträgertafel. Somit ist eine Redundanz der PCDU-Funktionen, der RIU-Funktionen, der OBC-Funktionen und der Power-Funktionen durch dieses Modular-Konzept realisierbar.

Eine besonders bevorzugte Anwendung der Erfindung erfolgt bei einem Kleinsatelliten, der nach dem Konzept der modularen Geräteträgertafeln in Rack-Form realisiert ist.

Zusammengefasst weist diese Ausführungsform folgende Eigenschaften auf:
- modulare Elektronikkästen (mit ARINC I/F) mechanisch integriert in eine "rackförmige" Tragestruktur, die auch die Wärme ableitet;
- elektrisch verbunden über ARINC-Stecker mit Harness-Bus;
- Hier ist die Zugänglichkeit mit IDAS (Integrated Data Acquisition Test System) und der neuen "IDAS T-Adapter Elektronikbox" gegeben.
- Sind sechs Geräteträgertafeln vorgesehen, die eine kastenartige geschlossene Struktur bilden, so geben die miteinander verbundenen Geräteträgertafeln der Rack Struktur mechanische Stabilität und leiten die Wärme in Richtung des kältesten Panels ab.

Von besonderem Vorteil ist es, wenn die Innenseite der Außenpanels mit "Sikaflex^{®}"-Folien versehen worden ist, welche an die Elektronikkästen pressen, um die Wärme abzuleiten. Die Wärme soll in Richtung der kältesten Geräteträgertafel, welche der Erde zugewandt ist, abgeleitet werden.

Sollte Platz für mehr Elektronikkästen erforderlich sein, kann durch Vergrößerung der Fläche jener Geräteträgertafel, die der Erde zugewandt ist, Montageraum für weitere Elektronikkästen und somit auch für eine weitere Wärmeabstrahlfläche zur Verfügung gestellt werden.

Die Integration der elektrischen und/oder elektronischen Baugruppen eines beschriebenen Satelliten muss beim erfindungsgemäßen Satelliten nicht mehr vollständig am Integrationsplatz erfolgen, sondern es kann mit vorgefertigten und getesteten Baugruppen gearbeitet werden, die dann nur noch in den Satelliten integriert werden müssen.

Zunächst erfolgt die Vormontage von zumindest einer Dockingstruktur für jede Seite einer Geräteträgertafel wobei im Inneren der Dockingstruktur elektrische Versorgungs- und Verbindungseinrichtungen verlegt und mit an den Seiten der Dockingstruktur vorgesehenen elektrischen Verbindungsmitteln zur Bildung eines Kabelbus' verbunden werden. Dieser in der Dockingstruktur verlegte Kabelbus wird dann getestet. Anschließend wird die Dockungstruktur mit dem getesteten und funktionsfähigen Kabelbus auf der zugeordneten Seite der Geräteträgertafel angebracht.

Parallel oder zeitlich versetzt dazu erfolgt die Vormontage der einzelnen Elektronikkästen, indem dessen elektrische und/oder elektronische Baugruppen (elektronische Geräte und/oder elektronische Schaltungsanordnungen) und Anordnungen von zumindest einer der Baugruppen in den zugeordneten Elektronikkasten integriert, also eingebaut und vorzugsweise mittels einer integrierten Selbsttesteinrichtung getestet werden.

Schließlich erfolgt die sequentielle mechanische Montage (Integration) der Elektronikkästen inclusive elektrischer Verifikation der elektrischen Schnittstellen mit Hilfe von IDAS und eingebautem Selbsttest bevor die Elektronikkästen endgültig mit der Dockingstruktur elektrisch verbunden werden.

Auf diese Weise ist eine erste mit Dockingstruktur und daran angeschlossenen Elektronikkästen versehene Geräteträgertafel gebildet.

Auf die gleiche Weise werden dann weitere Geräteträgertafeln ausgerüstet. Die fertig bestückten und getesteten Geräteträgertafeln werden dann in den Satelliten integriert.

Bezugszeichen in den Ansprüchen, der Beschreibung und den Zeichnungen dienen lediglich dem besseren Verständnis der Erfindung und sollen den Schutzumfang nicht einschränken. Die einzelnen Merkmale der gezeigten, beschriebenen und in den Ansprüchen beanspruchten Varianten und Weiterbildungen der Erfindung können im Rahmen der Erfindung beliebig miteinander kombiniert werden.

### Bezugszeichenliste

Es bezeichnen:
- 1: Geräteträgertafel
- 2: Dockingstruktur
- 2A: Dockingstruktur
- 2A': Dockingstruktur
- 2A": Dockingstruktur
- 2B: doppel-T-förmige Dockingstruktur
- 2B': doppel-T-förmige Dockingstruktur
- 2B": doppel-T-förmige Dockingstruktur
- 3: Elektronikkästen
- 3': Stirnseite
- 3": Unterseite
- 4: mechanische Verbindungsmittel
- 5: erste elektrische Verbindungsmittel
- 6: elektrische Versorgungs- und Verbindungsleitungen
- 7: zweite elektrische Verbindungsmittel
- 10: Grundplatte
- 12: Geräteträgertafel
- 13: Geräteträgertafel
- 14: Geräteträgertafel
- 16: Geräteträgertafel
- 17: Geräteträgertafel
- 18: Geräteträgertafel
- 20: Gittergerüst
- 22: innere Seite
- 24: äußere Seite
- 26: obere Seite/Oberseite
- 28: Abdeckplatten
- 30: mechanische Gegenverbindungsmittel
- 31: mechanische Gegenverbindungsmittel
- 32: elektrische Gegenverbindungsmittel
- 33: elektrische Gegenverbindungsmittel
- 34: elektrische Gegenverbindungsmittel
- 40: Schiene
- 41: Wärmekontaktfläche/thermische Kontaktplatte
- 42: Schiene
- 43: Wärmekontaktfläche/thermische Kontaktplatte
- 45: Wärmekontaktfläche/thermische Kontaktplatte
- 50: elektrische Steckverbinder
- 52: elektrische Steckverbinder
- 54: elektrische Steckverbinder
- 60: Kabelbaum
- 62: Kabelbaum
- 64: Kabelbaum
- 70: elektrische Steckverbinder
- 71: elektrische Steckverbinder
- 72: elektrische Steckverbinder
- 73: Gegensteckverbinder
- 74: Gegensteckverbinder

- S: Struktur

## Patentansprüche

1. Geräteträgertafel eines Satelliten mit einer Mehrzahl von elektrische und/oder elektronische Baugruppen aufnehmenden Elektronikkästen (3), wobei die Elektronikkästen untereinander elektrisch verbunden oder verbindbar sind,
- wobei die Geräteträgertafel (1; 12, 13, 14; 16, 17, 18) mit zumindest einer Dockingstruktur (2; 2A, 2A', 2A";2B, 2B', 2B") versehen ist;
- wobei eine Grundplatte (10) der Geräteträgertafel (1; 12, 13, 14; 16, 17, 18) und vorzugsweise die zumindest eine Dockingstruktur (2; 2A, 2A', 2A"; 2B, 2B', 2B") erste mechanische Verbindungsmittel (20, 21) zur Halterung von Elektronikkästen (3) aufweist;
- wobei die zumindest eine Dockingstruktur (2; 2A, 2A', 2A";2B, 2B', 2B") erste elektrische Verbindungsmittel (22, 23, 24) zur elektrischen Verbindung mit den Elektronikkästen (3) aufweist und
- wobei die Elektronikkästen (3) mit mechanischen Gegenverbindungsmitteln (30, 31) und elektrischen Gegenverbindungsmitteln (32, 33, 34) versehen sind, um damit einen jeweiligen Elektronikkasten (3) an der Dockingstruktur (2; 2A, 2A', 2A";2B, 2B', 2B") und/oder der Geräteträgertafel (1; 12, 13, 14; 16, 17, 18) mechanisch zu haltern und elektrisch zu kontaktieren,
**dadurch gekennzeichnet,**
- **dass** die Grundplatte (10) im Bereich der ersten mechanischen Verbindungsmittel (20, 21) mit Wärmekontaktflächen (41, 43, 45) versehen ist, auf denen ein mit den mechanischen Verbindungsmitteln (20, 21) in Eingriff stehender Elektronikkasten (3) mit einer Gehäusefläche an seiner Unterseite (3") in wärmeleitendem Kontakt aufliegt.

2. Geräteträgertafel nach Anspruch 1,
**dadurch gekennzeichnet,**
- **dass** die ersten mechanischen Verbindungsmittel (4) und die ersten elektrischen Verbindungsmittel (5) der Dockingstruktur (2; 2A, 2A', 2A";2B, 2B', 2B") an zumindest einer Seite (20) der Dockingstruktur (2; 2A, 2A', 2A";2B, 2B', 2B") in gleichmäßigem Abstand und in einer vorgegebenen, sich entlang der Seite (22) der Dockingstruktur (2; 2A, 2A', 2A";2B, 2B', 2B") vorzugsweise wiederholender Anordnung vorgesehen sind und so ein Aufnahmeraster für die Elektronikkästen (3) bilden und
- **dass** die mechanischen Gegenverbindungsmittel (30, 31) und die elektrischen Gegenverbindungsmittel (32, 33, 34) der Elektronikkästen (3) in ihrer Positionierung am betreffenden Elektronikkasten (3) und in ihrem Abstand zueinander an die Positionierung und den relativen Abstand der ersten mechanischen Verbindungsmittel (4) und der ersten elektrischen Verbindungsmittel (5) der Dockingstruktur (2; 2A, 2A', 2A";2B, 2B', 2B") angepasst sind.

3. Geräteträgertafel nach einem der vorhergehenden Ansprüche,
**dadurch gekennzeichnet,**
**dass** die jeweilige Dockingstruktur (2A; 2B) zweite elektrische Verbindungsmittel (7) und vorzugsweise auch zweite mechanische Verbindungsmittel aufweist, über die die Dockingstruktur (2A; 2B) mit einer weiteren Dockingstruktur (2A', 2A"; 2B, 2B") verbindbar ist.

4. Geräteträgertafel nach einem der vorhergehenden Ansprüche
**dadurch gekennzeichnet,**
**dass** die Dockingstruktur (2; 2A, 2A', 2A";2B, 2B', 2B") als gitterartiges Kastenprofil ausgebildet ist, in dessen Innerem elektrische Versorgungs- und Verbindungsleitungen (6) verlaufen, die mit den elektrischen Verbindungsmitteln (5, 7) verbunden sind.

5. Geräteträgertafel nach einem der vorhergehenden Ansprüche,
**dadurch gekennzeichnet,**
**dass** die Dockingstruktur (2; 2A, 2A', 2A"; 2B, 2B', 2B") auf der zugeordneten Geräteträgertafel (1; 12, 13, 14; 16, 17, 18) als rechteckiger Ring (2; 2A, 2A', 2A") oder als I-förmiger Balken (2B, 2B', 2B") ausgebildet ist.

6. Geräteträgertafel nach Anspruch 5,
**dadurch gekennzeichnet,**
**dass** die ersten mechanischen Verbindungsmittel (4) und die ersten elektrischen Verbindungsmittel (5) zur Anbringung der Elektronikkästen (3) an den seitlichen Flächen der Dockingstruktur (2; 2A, 2A', 2A"; 2B, 2B', 2B") vorgesehen sind, wobei sie bei einer ringförmigen Dockingstruktur (2; 2A, 2A', 2A") vorzugsweise auf der Innenseite des Rings ausgebildet sind.

7. Geräteträgertafel nach Anspruch 3,
**dadurch gekennzeichnet,**
**dass** die zweiten elektrischen Verbindungsmittel (7) Steckverbinder (73, 74; 73', 74'), die an oberen Flächen der Dockingstruktur (2A', 2A"; 2B', 2B") vorgesehen sind, und Gegensteckverbinder (70, 71, 72; 70', 71', 72') aufweisen, die an seitlichen Flächen der Dockingstruktur (2) im Bereich des Randes der zugeordneten Geräteträgertafel (12, 13, 14; 16, 17, 18) vorgesehen sind, wobei die Gegensteckverbinder (70, 71, 72) bei einer ringförmigen Dockingstruktur (2A, 2A', 2A") vorzugsweise auf der Außenseite des Rings ausgebildet sind.

8. Geräteträgertafel nach einem der vorhergehenden Ansprüche
**dadurch gekennzeichnet,**
**dass** die in eine einem jeweiligen Elektronikkasten (3) vorgesehenen elektrischen und/oder elektronischen Baugruppen mit einer Selbsttesteinrichtung versehen sind, die ausgebildet ist, um die Funktionsfähigkeit des entsprechenden Elektronikkastens (3) zu überprüfen.

9. Satellit mit einer Mehrzahl von Geräteträgertafeln nach einem der vorhergehenden Ansprüche.

10. Verfahren zur Integration von mit elektrische und/oder elektronische Baugruppen aufweisenden Elektronikkästen ausgestatteten Geräteträgertafeln nach einem der Ansprüche 1 bis 8 in einen Satelliten,
**gekennzeichnet durch** die Schritte:
- Vormontage von zumindest einer Dockingstruktur (2) wobei im Inneren der Dockingstruktur elektrische Versorgungs- und Verbindungseinrichtungen verlegt und mit an den Seiten der Dockingstruktur vorgesehenen elektrischen Verbindungsmitteln zur Bildung eines Kabelbus' verbunden werden;
- Testen des Kabelbus';
- Anbringen einer Dockingstruktur mit dem getesteten und funktionsfähigen Kabelbus auf einer ersten Seite der Geräteträgertafel;
- optionales Anbringen einer weiteren Dockingstruktur mit einem getesteten und funktionsfähigen Kabelbus auf einer von der ersten Seite abgewandten zweiten Seite der Geräteträgertafel;
- Bereitstellen von zumindest einem Elektronikkasten, in den elektrische und/oder elektronische Baugruppen und Anordnungen von zumindest einer der Baugruppen integriert, also eingebaut und, vorzugsweise mittels einer integrierten Selbsttesteinrichtung, getestet worden sind;
- sequentielle Integration des zumindest einen Elektronikkastens mit der Geräteträgertafel, wobei jeweils folgende Schritte durchgeführt werden:
-- vorläufige mechanische Anbringung des Elektronikkastens auf einer Grundplatte der Geräteträgertafel;
-- elektrische Verifikation der elektrischen Schnittstelle zwischen dem Elektronikkasten und dem Kabelbus;
-- Herstellen einer lösbaren elektrischen Verbindung zwischen dem Elektronikkasten und dem Kabelbaum mittels der ersten elektrischen Verbindungsmittel und der elektrischen Gegenverbindungsmittel;
- Integration der auf diese Weise vorgefertigten Geräteträgertafel (10) in den Satelliten.

11. Verfahren nach Anspruch 10,
**dadurch gekennzeichnet,**
**dass** die Herstellung der elektrischen Steckverbindung zwischen einem Elektronikkasten und der Dockingstruktur im Moment der endgültigen mechanischen Verbindung zwischen Elektronikkasten und Dockingstruktur erfolgt.

## Claims

1. A device carrier panel of a satellite, having a plurality of electronic boxes (3) that accommodate electrical and/or electronic modules, the electronic boxes being electrically connected or connectable to one another,
- wherein the device carrier panel (1; 12, 13, 14; 16, 17, 18) is provided with at least one docking structure (2; 2A, 2A', 2A"; 2B, 2B', 2B");
- wherein a base plate (10) of the device carrier panel (1; 12, 13, 14; 16, 17, 18) and preferably the at least one docking structure (2; 2A, 2A', 2A"; 2B, 2B', 2B") have first mechanical connecting means (20, 21) for holding electronic boxes (3);
- wherein the at least one docking structure (2; 2A, 2A', 2A"; 2B, 2B', 2B") has first electrical connecting means (22, 23, 24) for electrical connection to the electronic boxes (3); and
- wherein the electronic boxes (3) are provided with mechanical mating connection means (30, 31) and electrical mating connection means (32, 33, 34) for respectively mechanically holding and electrically contacting a particular electronic box (3) on the docking structure (2; 2A, 2A', 2A"; 2B, 2B', 2B") and/or the device carrier panel (1; 12, 13, 14; 16, 17, 18),
**characterized in that**
- the base plate (10) in the area of the first mechanical connecting means (20, 21) is provided with heat contact surfaces (41, 43, 45) on which an electronic box (3) that is engaged with the mechanical connecting means (20, 21) rests in heat-conducting contact with the underside (3") of a housing surface.

2. The device carrier panel according to Claim 1,
**characterized in that**
- the first mechanical connecting means (4) and the first electrical connecting means (5) of the docking structure (2; 2A, 2A', 2A"; 2B, 2B', 2B") are provided, on at least one side (20) of the docking structure (2; 2A, 2A', 2A"; 2B, 2B', 2B"), with uniform spacing and in a predefined, preferably repeating arrangement along the side (22) of the docking structure (2; 2A, 2A', 2A"; 2B, 2B', 2B"), thus forming a holding grid for the electronic boxes (3); and
- the mechanical mating connection means (30, 31) and the electrical mating connection means (32, 33, 34) of the electronic boxes (3) are adapted, in their positioning on the electronic box (3) in question and in their spacing from one another, to the positioning and the relative spacing between the first mechanical connecting means (4) and the first electrical connecting means (5) of the docking structure (2; 2A, 2A', 2A"; 2B, 2B', 2B").

3. The device carrier panel according to one of the preceding claims,
**characterized in that**
the particular docking structure (2A; 2B) has second electrical connecting means (7) and preferably also second mechanical connecting means, via which the docking structure (2A; 2B) is connectable to a further docking structure (2A', 2A"; 2B, 2B").

4. The device carrier panel according to one of the preceding claims,
**characterized in that**
the docking structure (2; 2A, 2A', 2A"; 2B, 2B', 2B") is designed as a grid-like box profile having electrical supply and connecting lines (6) extending in its interior which are connected to the electrical connecting means (5, 7).

5. The device carrier panel according to one of the preceding claims,
**characterized in that**
the docking structure (2; 2A, 2A', 2A"; 2B, 2B', 2B") on the associated device carrier panel (1; 12, 13, 14; 16, 17, 18) is designed as a rectangular ring (2; 2A, 2A', 2A") or as an I-shaped beam (2B, 2B', 2B").

6. The device carrier panel according to Claim 5,
**characterized in that**
the first mechanical connecting means (4) and the first electrical connecting means (5) are provided for mounting the electronic boxes (3) on the lateral surfaces of the docking structure (2; 2A, 2A', 2A"; 2B, 2B', 2B"), and for a ring-shaped docking structure (2; 2A, 2A', 2A") are preferably provided on the inner side of the ring.

7. The device carrier panel according to Claim 3,
**characterized in that**
the second electrical connecting means (7) have plug-in connectors (73, 74; 73', 74') that are provided on upper surfaces of the docking structure (2A', 2A"; 26', 2B"), and mating connectors (70, 71, 72; 70', 71', 72') that are provided on lateral surfaces of the docking structure (2) in the area of the edge of the associated device carrier panel (12, 13, 14; 16, 17, 18), whereby for a ring-shaped docking structure (2A, 2A', 2A") the mating connectors (70, 71, 72) are preferably provided on the outer side of the ring.

8. The device carrier panel according to one of the preceding claims,
**characterized in that**
the electrical and/or electronic modules that are provided in a particular electronic box (3) are provided with a self-testing device that is designed for checking the functionality of the electronic box (3) in question.

9. A satellite having a plurality of device carrier panels according to one of the preceding claims.

10. A method for integrating device carrier panels according to one of Claims 1 to 8, equipped with electronic boxes having electrical and/or electronic modules, into a satellite, **characterized by** the following steps:
- preassembling at least one docking structure (2), whereby electrical supply and connecting devices are placed in the interior of the docking structure and connected to electrical connecting means, provided on the sides of the docking structure, to form a cable bus;
- testing the cable bus;
- mounting a docking structure together with the tested and operational cable bus on a first side of the device carrier panel;
- optionally mounting a further docking structure together with a tested and operational cable bus on a second side of the device carrier panel facing away from the first side;
- providing at least one electronic box into which electrical and/or electronic modules and assemblies of at least one of the modules have been integrated, i.e., installed, and preferably tested by means of an integrated self-testing device;
- sequentially integrating the at least one electronic box with the device carrier panel, in each case carrying out the following steps:
-- provisionally mechanically mounting the electronic box on a base plate of the device carrier panel;
-- electrically verifying the electrical interface between the electronic box and the cable bus;
-- establishing a detachable electrical connection between the electronic box and the cable harness, using the first electrical connecting means and the electrical mating connection means;
- Integrating the device carrier panel (10) preassembled in this manner into the satellite.

11. The method according to Claim 10,
**characterized in that**
establishing the electrical plug-in connection between an electronic box and the docking structure takes place at the moment of the final mechanical connection between the electronic box and the docking structure.

## Revendications

1. Panneau de support d'équipements pour satellite, comprenant
plusieurs boîtiers électroniques (3) destinés à recevoir des modules électriques et/ou électroniques, ces boîtiers électroniques (3) étant ou pouvant être reliés électriquement entre eux,
- le panneau de support d'équipements (1; 12, 13, 14; 16, 17, 18) étant pourvu d'au moins une structure d'accueil (2; 2A, 2A', 2A"; 2B, 2B', 2B") ;
- une plaque de base (10) du panneau de support d'équipements (1; 12, 13, 14; 16, 17, 18) et préférentiellement ladite au moins une structure d'accueil (2; 2A, 2A', 2A"; 2B, 2B', 2B") présentant des premiers moyens de connexion mécanique (20, 21) servant au maintien des boîtiers électroniques (3) ;
- ladite au moins une structure d'accueil (2; 2A, 2A', 2A"; 2B, 2B', 2B") présentant des premiers moyens de connexion électrique (22, 23, 24) pour le raccordement électrique des boîtiers électroniques (3), et
- les boîtiers électroniques (3) étant pourvus de contre-moyens de connexion mécanique (30, 31) et de contre-moyens de connexion électrique (32, 33, 34) servant respectivement au maintien mécanique d'un boîtier électronique (3) et à sa mise en contact électrique sur la structure d'accueil (2; 2A, 2A', 2A"; 2B, 2B', 2B") et/ou sur le panneau de support d'équipements (1; 12, 13, 14; 16, 17, 18),
**caractérisé en ce que**
- la plaque de base (10) est pourvue dans la zone des premiers moyens de connexion mécanique (20, 21) de surfaces de contact thermique (41, 43, 45), sur lesquelles repose un boîtier électronique (3) qui est en prise avec les moyens de connexion mécanique (20, 21), et avec lesquelles surfaces il se trouve en contact thermoconducteur par l'intermédiaire d'une surface de boîtier située sur sa face inférieure (3").

2. Panneau de support d'équipements selon la revendication 1,
**caractérisé en ce que**
- les premiers moyens de connexion mécanique (4) et les premiers moyens de connexion électrique (5) de la structure d'accueil (2; 2A, 2A', 2A"; 2B, 2B', 2B") sont prévus sur au moins un côté (20) de la structure d'accueil (2; 2A, 2A', 2A"; 2B, 2B', 2B"), placés à égale distance et selon une disposition prédéfinie préférentiellement répétitive le long du côté (22) de la structure d'accueil (2; 2A, 2A', 2A"; 2B, 2B', 2B") pour former ainsi des ouvertures formant logements pour les boîtiers électroniques (3),
et **en ce que**
- les contre-moyens de connexion mécanique (30, 31) et les contre-moyens de connexion électrique (32, 33, 34) des boîtiers électroniques (3) sont, quant à leur positionnement sur le boîtier électronique (3) concerné et à leur espacement mutuel, adaptés au positionnement et à l'espacement relatif des premiers moyens de connexion mécanique (4) et des premiers moyens de connexion électrique (5) de la structure d'accueil (2; 2A, 2A', 2A"; 2B, 2B', 2B").

3. Panneau de support d'équipements selon l'une des revendications précédentes
**caractérisé en ce que**
la structure d'accueil (2A; 2B) respective présente des seconds moyens de connexion électrique (7) et préférentiellement également des seconds moyens de connexion mécanique par le biais desquels la structure d'accueil (2A; 2B) peut être reliée à une autre structure d'accueil (2A', 2A"; 2B, 2B").

4. Panneau de support d'équipements selon l'une des revendications précédentes
**caractérisé en ce que**
la structure d'accueil (2; 2A, 2A', 2A"; 2B, 2B', 2B") est réalisée sous la forme d'un profilé caisson formant grille, à l'intérieur duquel passent des câbles de connexion et d'alimentation électriques (6) auxquels sont reliés les moyens de connexion électrique (5, 7).

5. Panneau de support d'équipements selon l'une des revendications précédentes
**caractérisé en ce que**
la structure d'accueil (2; 2A, 2A', 2A"; 2B, 2B', 2B") est réalisée sur le panneau de support d'équipements (1; 12, 13, 14; 16, 17, 18) correspondant sous la forme d'une boucle rectangulaire (2; 2A 2A', 2A") ou sous la forme d'une barre en I (2B, 2B', 2B").

6. Panneau de support d'équipements selon la revendication 5,
**caractérisé en ce que**
les premiers moyens de connexion mécanique (4) et les premiers moyens de connexion électrique (5) sont prévus sur les faces latérales de la structure d'accueil (2; 2A, 2A', 2A"; 2B, 2B', 2B") pour permettre le montage des boîtiers électroniques (3), lesdits moyens étant, dans le cas d'une structure d'accueil en forme de boucle, préférentiellement réalisés sur le côté intérieur de la boucle.

7. Panneau de support d'équipements selon la revendication 3,
**caractérisé en ce que**
les seconds moyens de connexion électrique (7) présentent des connecteurs enfichables (73, 74; 73', 74') prévus sur les faces supérieures de la structure d'accueil (2; 2A, 2A', 2A"; 2B, 2B', 2B") et des contre-connecteurs enfichables (70, 71, 72; 70', 71', 72') prévus sur les faces latérales de la structure d'accueil (2) dans la zone du bord du panneau de support d'équipements associé (12, 13, 14; 16, 17, 18), les contre-connecteurs enfichables (70, 71, 72) étant, dans le cas d'une structure d'accueil (2A, 2A', 2A") en forme de boucle, préférentiellement réalisés sur le côté extérieur de la boucle.

8. Panneau de support d'équipements selon l'une des revendications précédentes,
**caractérisé en ce que**
les modules électriques et/ou électroniques prévus dans un boîtier électronique (3) sont pourvus d'un dispositif d'autocontrôle qui est conçu pour vérifier la capacité de fonctionnement du boîtier électronique (3) correspondant.

9. Satellite comportant plusieurs panneaux de support d'équipements selon l'une des revendications précédentes.

10. Procédé pour intégrer dans un satellite des panneaux de support d'équipements équipés de boîtiers électroniques présentant des modules électriques et/ou électroniques selon l'une des revendications 1 à 8,
**caractérisé par** les étapes suivantes :
- le pré-assemblage d'au moins une structure d'accueil (2), des dispositifs de connexion et d'alimentation électriques étant montés à l'intérieur de la structure d'accueil et reliés aux moyens de connexion électrique prévus sur les côtés de la structure d'accueil pour former un bus',
- le test du bus',
- le montage d'une structure d'accueil équipée du bus' testé et opérationnel sur un premier côté du panneau de support d'équipements,
- le montage facultatif d'une structure d'accueil supplémentaire équipée d'un bus testé et opérationnel sur un deuxième côté du panneau de support d'équipements opposé audit premier côté,
- la mise à disposition d'au moins un boîtier électronique à l'intérieur duquel des composants et ensembles électriques et/ou électroniques d'au moins un des modules ont été intégrés, soit incorporés, et testés préférentiellement au moyen du dispositif d'autocontrôle intégré,
- l'intégration séquentielle dudit au moins un boîtier électronique avec le panneau de support d'équipements, les étapes suivantes étant respectivement effectuées :
-- le montage mécanique préliminaire du boîtier électronique sur une plaque de base du panneau de support d'équipements,
-- la vérification électrique de l'interface électrique entre le boîtier électronique et le bus,
-- la réalisation d'une connexion électrique détachable entre le boîtier électronique et le faisceau de câbles au moyen des premiers moyens de connexion électrique et des contre-moyens de connexion électrique,
-- l'intégration dans le satellite du panneau de support d'équipements (10) ainsi préfabriqué.

11. Procédé selon la revendication 10,
**caractérisé en ce que**
l'établissement de la connexion électrique enfichable entre un boîtier électronique et la structure d'accueil se fait à l'instant où est réalisée la connexion mécanique finale entre le boîtier électronique et la structure d'accueil.
